# EUROPEAN PATENT APPLICATION

(11) **EP 4 206 366 A1**
(43) Date of publication of application: **05.07.2023**
(21) Application number: 21861712.4
(22) Date of filing: 27.08.2021
(51) Int. Cl.: C30B 29/36, C30B 23/02

(54) **SIC POLYCRYSTAL MANUFACTURING METHOD**

(30) Priority: 28.08.2020 JP 2020144558
(71) Applicant: Kyocera Corporation, Kyoto-shi Kyoto 612-8501 (JP)
(72) Inventor: ITOU, Seiichirou, Kyoto-shi, Kyoto 612-8501 (JP); ISHIZAKI, Yuichiro, Kyoto-shi, Kyoto 612-8501 (JP); UMEKI, Haruki, Kyoto-shi, Kyoto 612-8501 (JP)
(74) Representative: Viering, Jentschura & Partner mbB Patent- und Rechtsanwälte
(86) International application number: PCT/JP2021/031503
(87) International publication number: WO 2022/045291

(57) **Abstract**

Provided is a SiC polycrystal manufacturing method based on a sublimation recrystallization method using a SiC seed crystal. In the method, a polycrystalline SiC substrate that is a SiC polycrystal produced by a sublimation recrystallization method and contains a greater amount of α-SiC than β-SiC is used as the SiC seed crystal.

## Description

### TECHNICAL FIELD

The present disclosure relates to a method for manufacturing a SiC polycrystal.

### BACKGROUND OF INVENTION

A known existing method for manufacturing SiC polycrystals includes defining a space between the ceiling of a graphite vessel and the rear surface of a seed crystal by disposing the seed crystal on a shelf of the graphite vessel, disposing Si and C atom sources inside the graphite vessel, heating a furnace, and promoting gas phase transport from the Si and C atom sources to the seed crystal while making it unlikely that the rear surface of the seed will contact the ceiling by evacuating the induction furnace and directing a gas flow from below the seed crystal through the regions around the seed crystal to the center of the space between the ceiling of the graphite vessel and the seed crystal (refer to, for example, Japanese Unexamined Patent Application Publication (Translation of PCT Application) No. 2016-508948).

### SUMMARY

The present disclosure provides a SiC polycrystal manufacturing method based on a sublimation recrystallization method using a SiC seed crystal.

A polycrystalline SiC substrate that is a SiC polycrystal produced by a sublimation recrystallization method and contains a greater amount of α-SiC than β-SiC is used as the SiC seed crystal.

### BRIEF DESCRIPTION OF THE DRAWINGS

FIG. 1 is a cross-sectional view of a manufacturing apparatus according to an embodiment of the present disclosure taken along the vertical direction.
FIG. 2 is a sectional view of a variation of a SiC seed crystal of the manufacturing apparatus in FIG. 1 taken along the vertical direction.
FIG. 3 is a diagram for explaining the flow of electrons inside a SiC seed crystal.
FIG. 4 is a diagram for explaining the flow of electrons inside a SiC seed crystal.
FIG. 5 is a sectional view of part of the manufacturing apparatus in FIG. 1 taken along the vertical direction.
FIG. 6A is a sectional view illustrating one step of a SiC polycrystal manufacturing method according to the embodiment.
FIG. 6B is a sectional view illustrating another step of the manufacturing method.
FIG. 6C is a sectional view illustrating another step of the manufacturing method.
FIG. 6D is a sectional view illustrating another step of the manufacturing method.
FIG. 6E is a sectional view illustrating another step of the manufacturing method.
FIG. 7A is a sectional view illustrating one step of the SiC polycrystal manufacturing method according to the embodiment.
FIG. 7B is a sectional view illustrating another step of the manufacturing method.
FIG. 8A is a sectional view of a SiC polycrystal manufactured using a manufacturing method of the related art taken along the growth direction.
FIG. 8B is a sectional view of a SiC polycrystal manufactured using a manufacturing method according to the present disclosure taken along the growth direction.
FIG. 9A is a sectional view of a SiC seed crystal and a SiC polycrystal manufactured using the manufacturing method of the related art taken along the growth direction.
FIG. 9B is a sectional view of a SiC seed crystal and a SiC polycrystal manufactured using a manufacturing method according to the present disclosure taken along the growth direction.

### DESCRIPTION OF EMBODIMENTS

In recent years, SiC polycrystals having higher thermal conductivity have been demanded.

According to the present disclosure, the thermal conductivity of manufactured SiC polycrystals can be improved from what was previously possible.

Hereafter, an embodiment of the present disclosure will be described in detail while referring to the drawings.

However, the technical scope of the present disclosure is not limited to that exemplified in the following embodiment and drawings.

### (1. SiC Polycrystal Manufacturing Apparatus)

First, the configuration of a manufacturing apparatus 100 (furnace) used in the manufacture of a silicon carbide (SiC) polycrystal C according to this embodiment will be described.

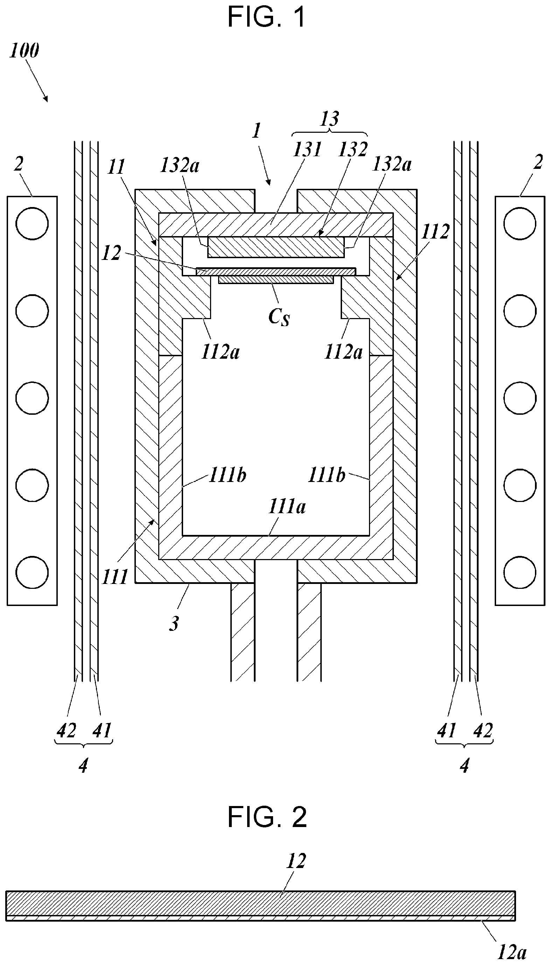

FIG. 1 is a cross section of the manufacturing apparatus 100 according to this embodiment taken along the vertical direction (crystal growth direction).

The manufacturing apparatus 100 is used to manufacture a SiC polycrystal C using a sublimation recrystallization method.

As illustrated in FIG. 1, the manufacturing apparatus 100 according to this embodiment includes a vessel 1, a SiC seed crystal Cs, and a coil 2.

The manufacturing apparatus 100 according to this embodiment further includes a heat insulator 3 and a quartz tube 4.

### (Vessel)

The vessel 1 includes a crucible 11, a stress-buffering sheet 12, and a lid 13.

The crucible 11 according to this embodiment includes a crucible body 111 and a support member 112.

The crucible body 111 includes a bottom part 111a and a side wall 111b, and is open at the top thereof.

The material of the crucible body 111 according to this embodiment is carbon.

The support member 112 is a cylindrical member that extends in the vertical direction.

The material of the support member 112 according to this embodiment is carbon.

A plan view outline of the support member 112 is approximately the same as a plan view outline of the crucible. Therefore, the support member 112 can be placed on the top surface of the crucible 11.

An inner wall surface of the support member 112 includes a support portion 112a. The support portion 112a protrudes in the direction of a central axis of the support member 112.

The support portion 112a may be provided along the entire periphery of the inner wall surface, or a plurality of the support portions 112a may be provided at intervals from each other.

The crucible 11 may also be configured such that the crucible body and the support member are integrated with each other.

The stress-buffering sheet 12 a member on which the SiC polycrystal C grows on the bottom surface thereof.

The material of the stress-buffering sheet 12 according to this embodiment is carbon.

The stress-buffering sheet 12 is placed on the support portion 112a of the crucible 11.

The thickness of the stress-buffering sheet 12 according to this embodiment lies in a range of 0.3 to 2.0 mm.

As illustrated in FIG. 2, the stress-buffering sheet 12 may be provided with a high melting point protective film 12a on the bottom surface thereof.

The high melting point protective film 12a is, for example, composed of tantalum carbide (TaC).

Any of a variety of existing known techniques can be used to form the high melting point protective film 12a.

As illustrated in FIG. 1, the lid 13 includes a lid body 131 and a projection 132.

A plan view outline of the lid body 131 is substantially the same as a plan view outline of the crucible 11 (support member 112). Therefore, the lid body 131 can be placed on the top surface of the crucible 11.

The projection 132 projects from a surface (bottom surface) of the lid body 131 facing the stress-buffering sheet 12 towards a region (underside) of the stress-buffering sheet 12 where the SiC polycrystal C will grow.

The projection 132 projects with a width corresponding to that of the region on the bottom surface of the stress-buffering sheet 12 where the SiC polycrystal C will grow.

The "region where the SiC polycrystal C will grow" refers to the region of the bottom surface of the stress-buffering sheet 12 that is not overlapped by the support portion 112a (i.e., is not shielded by the support portion 112a and is visible when looking upward from inside the crucible body 111).

The projection 132 according to this embodiment is located within the region where the SiC polycrystal C will grow and overlaps 80% or more of that region when viewed in plan view.

A side surface 132a of the projection 132 may be inclined so that the width of the projection 132 decreases with increasing proximity to the lid body 131 (increasing separation from the stress-buffering sheet 12).

The side surface 132a of the projection 132 may be recessed.

The lid 13 may include multiple projections 132. This would increase the area of the surface of the lid 13 on which SiC gas can be adsorbed and the SiC gas would be more likely to recrystallize on the lid 13. Therefore, SiC would be less likely to recrystallize on the top surface of the stress-buffering sheet 12.

A space is formed between the lid 13 (projection 132) placed on the crucible 11 and the stress-buffering sheet 12.

The gap between the projection 132 and the stress-buffering sheet 12 is greater than the amount by which the stress-buffering sheet 12 will deform while the SiC polycrystal C is growing.

In other words, the distance between the projection 132 and the stress-buffering sheet 12 prior to crystal growth is such that an upper edge (peripheral edge) of the stress-buffering sheet 12, which bends and deforms so as to be downwardly convex during the growth of SiC polycrystal C, does not contact the bottom surface of the projection 132.

### (SiC Seed Crystal)

The SiC seed crystal Cs is a polycrystalline SiC substrate.

Polycrystalline SiC substrates are SiC polycrystals produced using a sublimation recrystallization method, and contain a greater amount of α-SiC (hexagonal crystals) than β-SiC (cubic crystals).

The polycrystalline SiC substrate may contain only α-SiC (does not need to contain β-SiC).

The polycrystalline SiC substrate also contains nitrogen (N) as a trace component (impurity).

Nitrogen is mixed in during the manufacture of the polycrystalline SiC substrate.

The concentration of nitrogen in the polycrystalline SiC substrate according to this embodiment is kept within a range of 5 × 10¹⁵ to 5 × 10¹⁷ atoms/cm³ (0.1 to 10 ppm).

The polycrystalline SiC substrate further contains at least one out of boron (B) and aluminum (Al) as a trace component.

Similarly to nitrogen, boron and aluminum are mixed in (rather than added) during the manufacture of the polycrystalline SiC substrate.

The concentration of boron in the polycrystalline SiC substrate according to this embodiment is controlled to be in a range of 5 × 10¹⁵ to 5×10¹⁷ atoms/cm³ (0.1 to 10 ppm).

The concentration when aluminum is included as a trace component, or when both boron and aluminum are included as trace components, is the same as or similar to the above concentration.

The polycrystalline SiC substrate contains at least one out of the metallic elements vanadium (V), scandium (Sc), and titanium (Ti) as a trace component.

The metallic elements are added during the manufacture of the polycrystalline SiC substrate.

The concentration of the metallic elements in the polycrystalline SiC substrate according to this embodiment is in a range of 1×10¹⁶ to 8×10¹⁷ atoms/cm³ (0.2 to 17 ppm).

In other words, the concentration of metallic elements in the polycrystalline SiC substrate is higher than that of nitrogen.

As described above, the polycrystalline SiC substrate according to this embodiment has a low concentration of nitrogen, which causes free electrons to be generated, and contains a greater amount of metallic elements than nitrogen.

The donor level of nitrogen is close to the conduction band of SiC. Therefore, nitrogen typically attempts to emit an electron e into the conduction band.

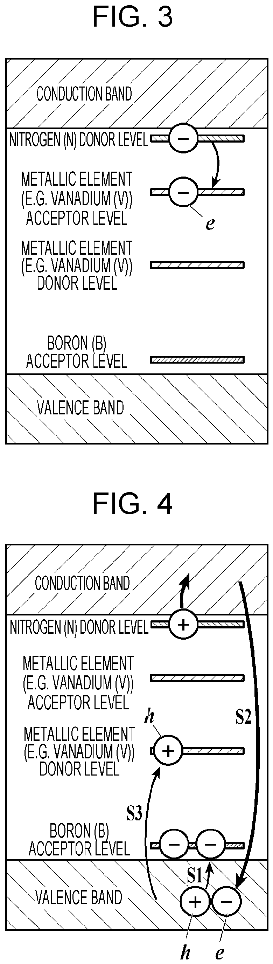

However, when metallic elements are added to a SiC crystal, as illustrated in FIG. 3, the acceptor levels of the metallic elements exist in the vicinity of the donor level of nitrogen and are closer to the valence band than the donor level of nitrogen. Therefore, an electron e in the donor level of nitrogen moves not to the conduction band but to the acceptor level of a metallic element, which is more stable than the conduction band.

Thus, the electrons e of nitrogen are supplemented by the metallic element, and the electrons e no longer flow through the conduction band of SiC.

The boron contained in the SiC crystal has an acceptor level in the vicinity of the valence band of SiC, as illustrated in FIG. 4. Therefore, boron steals an electron e from the valence band. As a result, a hole h (positive hole) is created in the valence band (Step S 1).

Due to the creation of the hole h in the valence band, which has lower energy than the conduction band, an electron e emitted from the donor level of nitrogen to the conduction band is readily incorporated into the valence band (Step S2), and the electron e no longer flows through the conduction band of SiC.

The above-described two mechanisms that suppress the flow of electrons e through the conduction band result in the SiC seed crystal Cs according to this embodiment having a low concentration of free electrons and high insulating properties (for example, a resistance of more than 1×10⁶ Ω when a voltage of 100 V is applied).

If the concentration of boron is higher than the concentration of nitrogen, an excess of holes will be generated in the valence band of SiC. However, when a metallic element is added to a boron-containing SiC crystal, the metallic element has a donor level that is closer to the valence band than an acceptor level, as illustrated in FIG. 4. Therefore, a hole h in the valence band moves to the donor level of the metallic element (Step S3). In this way, the holes h are supplemented by the metallic element and the holes h do not move through the conduction band of SiC. This mechanism is also the reason why the SiC seed crystal Cs according to this embodiment has high insulating properties.

Therefore, the concentration of the metallic elements in the polycrystalline SiC substrate is preferably higher than the difference between the concentrations of nitrogen and boron.

The thus-configured SiC seed crystal Cs is positioned on the bottom surface of the stress-buffering sheet 12 as illustrated in FIG. 1.

When the stress-buffering sheet 12 or SiC seed crystal Cs includes the high melting point protective film 12a, the polycrystalline SiC substrate is positioned on the bottom surface of the high melting point protective film 12a.

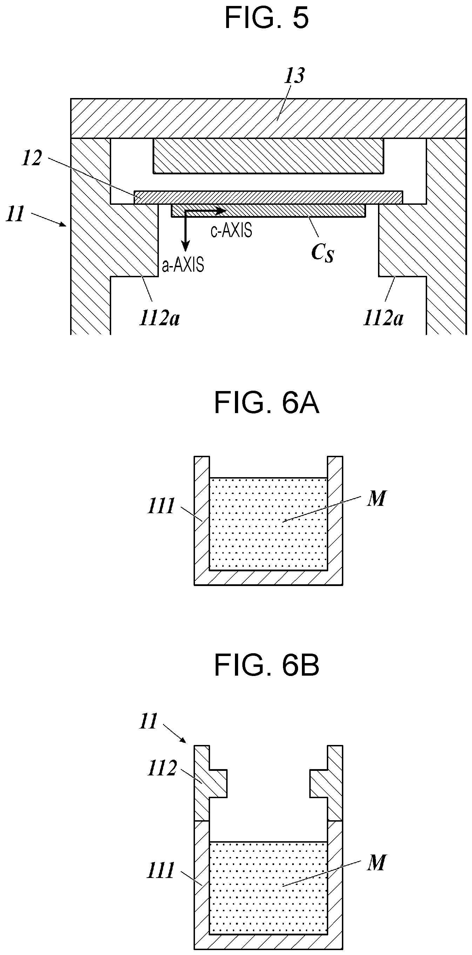

An a-axis of the SiC seed crystal Cs is oriented along the growth direction (vertical direction) of the SiC polycrystal C as illustrated in FIG. 5.

The polycrystalline SiC substrate may be subjected to a sealing process so as to close micropipes P.

Any of various existing known techniques may be used to close the micropipes P.

The SiC seed crystal Cs may have a high melting point protective film on its top surface instead of the stress-buffering sheet 12.

### (Heat Insulator)

As illustrated in FIG. 1, the heat insulator 3 covers the vessel 1.

### (Quartz Tube)

The quartz tube 4 surrounds heat insulator 3 from the outside.

The quartz tube 4 is a double tube consisting of an inner tube 41 and an outer tube 42.

Water can be passed between the inner tube 41 and the outer tube 42.

The quartz tube 4 may instead be a single-layer tube.

### (Coil)

The coil 2 is used to heat the vessel 1 by high-frequency induction heating.

The coil 2 surrounds the quartz tube 4 from the outside.

The vessel 1 may be heated by resistance heating using a heater instead of the coil 2. When resistance heating is used, the vessel 1 is heated by disposing the resistance heating inside the quartz tube 4.

### (2. SiC Polycrystal Manufacturing Method)

Next, a method for manufacturing the SiC polycrystal C using the manufacturing apparatus 100 will be described.

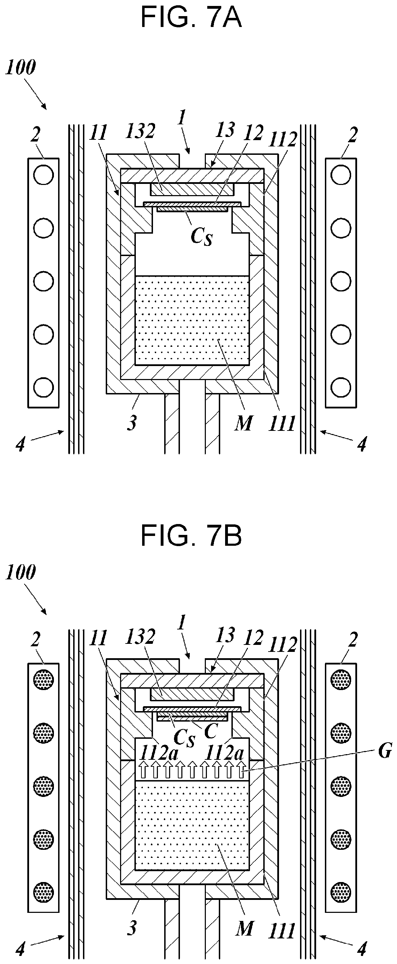

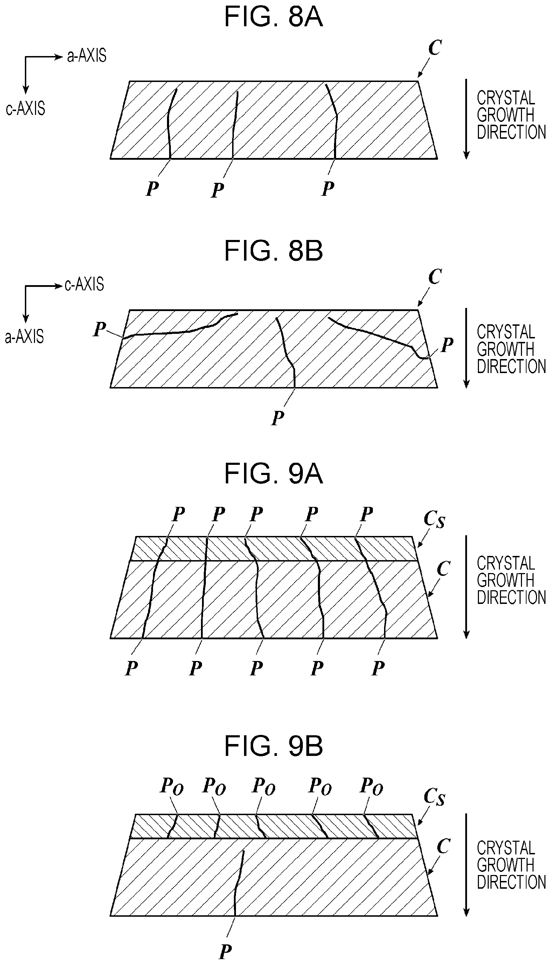

FIGs. 6A to 6E, FIG. 7A, and FIG. 7B are sectional views illustrating steps of the method for manufacturing the SiC polycrystal C. FIG. 8A is a sectional view of a SiC polycrystal manufactured using a manufacturing method of the related art taken along the growth direction. FIG. 8B is a sectional view of the SiC polycrystal C manufactured using a manufacturing method according to the present disclosure taken along the growth direction. FIG. 9A is a sectional view of a SiC seed crystal and a SiC polycrystal manufactured using the manufacturing method of the related art taken along the growth direction. FIG. 9B is a sectional view of a SiC seed crystal and the SiC polycrystal C manufactured using the manufacturing method according to the present disclosure taken along the growth direction.

### Manufacture of the SiC polycrystal C is performed using a sublimation recrystallization method.

The method for manufacturing the SiC polycrystal C includes a crucible preparation step, a raw material feeding step, a seed crystal attaching step, a stress-buffering sheet installation step, a lid installation step, and a growth step.

The method for manufacturing the SiC polycrystal C according to this embodiment further includes a support member installation step, an evacuation step, and a cooling/removal step.

### (Crucible Preparation Step)

In the initial crucible preparation step, the crucible 11 including the support portion 112a on the inner surface thereof is prepared.

### (Raw Material Feeding Step)

After the crucible 11 has been prepared, the process moves on to the raw material feeding step.

In the raw material feeding step, as illustrated in FIG. 6A, SiC polycrystal raw material M (SiC polycrystal powder and metallic elements to be added as trace components) is introduced into the crucible 11 (crucible body 111).

### (Support Member Installation Step)

Once the raw material M has been introduced into the crucible 11, the method for manufacturing the SiC polycrystal C according to this embodiment moves on to the support member installation step.

As illustrated in FIG. 6B, in the support member installation step, the support member 112 is installed on the crucible body 111 into which the raw material M has been introduced.

If the crucible 11 is a crucible in which the crucible body and the support member are integrated with each other, this support member installation step is not necessary.

### (Seed Crystal Attaching Step)

Before the stress-buffering sheet installation step described below, the process moves on to the seed crystal attaching step.

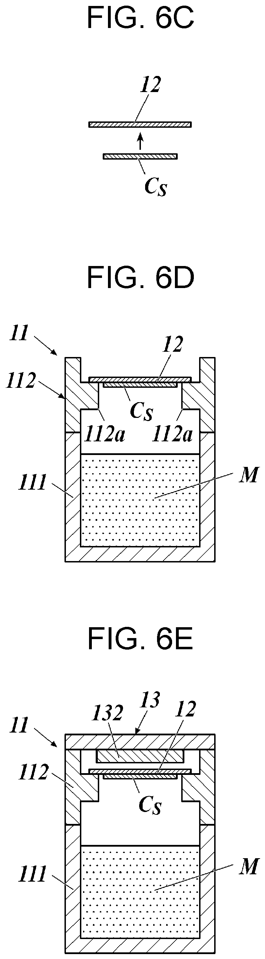

In the seed crystal attaching step, as illustrated in FIG. 6C, the polycrystalline SiC substrate is attached to the bottom surface of the stress-buffering sheet 12 as the SiC seed crystal C_{S}.

If the high melting point protective film 12a is disposed on the bottom surface of the stress-buffering sheet 12, the polycrystalline SiC substrate is attached to the bottom surface of the high melting point protective film 12a.

At this time, as illustrated in FIG. 5, the SiC seed crystal Cs is disposed such that the a-axis of the SiC seed crystal Cs is oriented along the growth direction of the SiC polycrystal C.

### (Stress-Buffering Sheet Installation Step)

Once the support member 112 has been installed on the crucible body 111, the process moves on to the stress-buffering sheet installation step.

In the stress-buffering sheet installation step, the stress-buffering sheet 12, which has a region on the lower surface thereof where the SiC polycrystal C will grow, is provided on the support portion 112a of the crucible 11.

Specifically, as illustrated in FIG. 6D, the peripheral portion of the stress-buffering sheet 12 is placed on the support portion 112a of the support member 112.

In the stress-buffering sheet installation step according to this embodiment, the thickness of the stress-buffering sheet 12 is in a range of 0.3 to 2.0 mm. In this way, the rigidity of the stress-buffering sheet 12 is maintained and a situation in which the growing SiC polycrystal C falls off can be avoided.

Note that the stress-buffering sheet 12 may be provided on the support portion 112a at a timing before installing the support member 112 on the crucible body 111.

In other words, the support member 112 may be placed on the crucible body 111 after placing the stress-buffering sheet 12 on the support portion 112a of the support member 112.

In the above case, the SiC seed crystal Cs may be attached to the bottom surface of the stress-buffering sheet 12 after installing the stress-buffering sheet 12 on the support portion 112a of the crucible 11, but before installing the support member on the crucible body 111.

### (Lid Installation Step)

After providing the stress-buffering sheet 12 on the support portion 112a of the crucible 11, the process moves on to the lid installation step.

In the lid installation step, the lid 13 including the projection 132 is installed on the crucible 11.

Specifically, as illustrated in FIG. 6E, the lid 13 is placed on the support member 112 so that the projection 132 is positioned inside the support member 112.

Thus, the projection 132 projects towards the region where the SiC polycrystal C will grow on the stress-buffering sheet 12.

In the support member installation step or the lid installation step, it is ensured that the gap between the projection 132 and the stress-buffering sheet 12 is larger than the amount by which the stress-buffering sheet 12 will deform while the SiC polycrystal C is growing.

Specifically, the width of the above-described space is secured by adjusting the distance between the top edge of the crucible 11 and the top surface of the support portion 112a, or the thickness of the projection 132 of the lid 13.

### (Vessel Installation Step)

Once the lid 13 has been installed on the crucible 11, the process moves on to a vessel installation step.

As illustrated in FIG. 7A, in the vessel installation step, the vessel 1 is disposed inside the heat insulator 3 of the manufacturing apparatus 100.

### (Evacuation Step)

Once the vessel 1 has been installed inside the heat insulator 3, the process moves on to the evacuation step.

In the evacuation step, the interior of the manufacturing apparatus 100 is evacuated and filled with an inert gas.

### (Growth Step)

Once the lid 13 has been installed on the crucible 11, the process moves on to the growth step.

In the growth step, as illustrated in FIG. 7B, the raw material M in the crucible 11 is sublimated so as to grow the SiC polycrystal C on the bottom surface of stress-buffering sheet 12.

Specifically, a high-frequency alternating current is energized in the coil 2. Then, high-density eddy currents are generated in the vessel 1. The vessel 1 is then heated up by the eddy currents up to the temperature at which the raw material M sublimates.

SiC gas G produced by the sublimation of the raw material M rises to the height of the stress-buffering sheet 12 and recrystallizes on the bottom surface of the stress-buffering sheet 12.

Some of the SiC gas G produced by the sublimation of the raw material M passes through the gap between the support portion 112a of the crucible 11 and the stress-buffering sheet 12 and flows around to the side where the lid 13 is located.

During the growth of SiC polycrystal C, the SiC gas G that has flowed around to the side where the lid 13 is located recrystallizes mainly on the side surface 132a of the projection 132. This makes it less likely that the SiC will recrystallize on the top surface of the stress-buffering sheet 12.

As a result, the stress buffering performance of the stress-buffering sheet 12 is maintained during the growth of the SiC polycrystal C, and the stress contained in the manufactured SiC polycrystal C is reduced from what was previously possible.

As described above, the projection 132 of the lid 13 according to this embodiment is located within the region where the SiC polycrystal C grows and overlaps 80% or more of that region when viewed in plan view. This makes it less likely for the SiC to recrystallize in numerous regions on the top surface of the stress-buffering sheet 12 during the growth step described above. As a result, a region where the stress-buffering sheet 12 can deform for the purpose of stress buffering can be sufficiently secured.

When the side surface 132a of the projection 132 is recessed or sloped so that the width of the projection 132 decreases with increasing separation from the stress-buffering sheet 12, the surface area of the projection 132 is increased. This increases the amount of adsorption of the SiC gas that has flowed around to the side where the lid 13 is located during the growth step, and therefore it becomes less likely for the SiC gas that has flowed around to the side where the lid 13 is located to reach the top surface of the stress-buffering sheet 12.

As described above, the space between the projection 132 and the stress-buffering sheet 12 according to this embodiment is larger than the amount of deformation of the stress-buffering sheet 12 that occurs while the SiC polycrystal C is growing. Therefore, in the growth step, further deformation of the deformed stress-buffering sheet 12 resulting from the stress-buffering sheet 12 contacting the projection 132 is obstructed, and degradation of the stress buffering function can be avoided.

As described above, the stress-buffering sheet 12 according to this embodiment is only placed on the support portion 112a of the crucible 11. This makes it more difficult for heat to be transferred from the crucible 11 to stress-buffering sheet 12 during the growth step, and this results in a uniform temperature distribution in planar directions (horizontal directions) of the stress-buffering sheet 12. As a result, flat SiC polycrystals C can be manufactured and the product yield is improved.

As mentioned above, the SiC seed crystal Cs is a SiC polycrystal produced by the sublimation recrystallization method and contains a greater amount of α-SiC than β-SiC. Therefore, a SiC polycrystal C (ingot) having few grain boundaries and high thermal conductivity can be manufactured from the initial stage of growth.

When the SiC seed crystal Cs is attached to the bottom surface of the high melting point protective film 12a, Si diffusing into the stress-buffering sheet 12 during the growth of SiC polycrystal C is reduced. Therefore, defects are less likely to occur in the growing SiC polycrystal C.

As described above, the SiC seed crystal Cs has a low concentration of nitrogen, which generates free electrons, and also contains a greater amount of metallic elements, which trap free electrons, than nitrogen, and therefore has a low concentration of free electrons. The properties of the SiC polycrystal C that is grown depend on the properties of the SiC seed crystal Cs. The raw material M also contains metallic elements for the purpose of reducing the concentration of free electrons. Therefore, a SiC polycrystal C having high insulation properties can be grown from the SiC seed crystal Cs.

As illustrated in FIG. 8A, the phenomenon that micropipes P in SiC crystals tend to grow along the c-axis is known.

However, the a-axis of the SiC seed crystal Cs according to this embodiment is oriented along the growth direction of the SiC polycrystal C, as described above.

The micropipes P are less likely to occur in a direction along the a-axis. Therefore, as the SiC polycrystal C grows, the micropipes P bend in a direction along the c-axis, which is perpendicular to the crystal growth direction, as illustrated in FIG. 8B. As a result, a SiC polycrystal C can be obtained that has fewer micropipes P that penetrate in the direction in which the crystal grows.

If a hole (one end of a micropipe P) where there is no crystal is exposed at the surface of the SiC seed crystal Cs, the micropipe P will continue into the inside of the SiC polycrystal C growing from the surface of the SiC seed crystal Cs, as illustrated in FIG. 9A.

However, when the SiC seed crystal Cs is sealed (only closed micropipes P₀ exists, as illustrated in FIG. 9B), a SiC polycrystal C having fewer micropipes P can be obtained because there are no remaining holes at the surface of the SiC seed crystal Cs.

### (Cooling/Removal Step)

Once a SiC polycrystal C of a prescribed length has been grown, the process moves on to the cooling/removal step.

In this cooling/removal step, the temperature inside the manufacturing apparatus 100 is lowered in stages.

Once the temperature inside the manufacturing apparatus 100 has fallen to a prescribed temperature, the vessel 1 is removed from inside the heat insulator 3, the stress-buffering sheet 12 is removed from the crucible 11, and the SiC polycrystal is removed from the stress-buffering sheet 12.

In this way, a SiC polycrystal C is manufactured.

The SiC seed crystal Cs used in the SiC polycrystal manufacturing method described above is produced using a sublimation recrystallization method, and therefore has a larger crystal grain size and fewer grain boundaries (higher thermal conductivity) than crystals produced using a CVD method of the related art.

The SiC seed crystal Cs contains a greater amount of α-SiC, which has higher thermal conductivity, than β-SiC.

The properties of SiC crystals produced using seed crystals depend on the properties of the seed crystals. Therefore, a SiC polycrystal C manufactured using the SiC seed crystal Cs according to this embodiment has few grain boundaries and contains a larger amount of α-SiC.

Therefore, according to the above method for manufacturing a SiC polycrystal, the thermal conductivity of the manufactured SiC polycrystal can be improved from what was previously possible.

It goes without saying that the present disclosure is not limited to the above embodiment and so forth and may be changed as appropriate without departing from the intent of the present disclosure.

For example, provided that the vessel 1 is a vessel that can be used to manufacture a SiC polycrystal C by a sublimation recrystallization method using a seed crystal, the vessel 1 is not particularly limited.

Specifically, for example, the lid 13 does not need to include the projection 132.

The stress-buffering sheet 12 may be attached to the lid 13 in the vessel 1.

The vessel 1 does not need to include the stress-buffering sheet 12. The SiC seed crystal Cs may be directly attached to the lid 13 or the support member 112.

### INDUSTRIAL APPLICABILITY

The present disclosure can be used in a method for manufacturing a SiC polycrystal.

### REFERENCE SIGNS

- 100: manufacturing apparatus
- 1: vessel
- 11: crucible
- 111: crucible body
- 111a: bottom part
- 111b: side wall
- 112: support member
- 112a: support portion
- 12: stress-buffering sheet
- 12a: high melting point protective film
- 13: lid
- 131: lid body
- 132: projection
- 132a: side surface
- 2: coil
- 3: heat insulator
- 4: quartz tube
- 41: inner tube
- 42: outer tube
- C: SiC polycrystal
- Cs: SiC seed crystal
- G: SiC gas
- M: raw material
- P: micropipe
- P₀: closed micropipe
- e: electron
- h: hole

## Claims

1. A SiC polycrystal manufacturing method based on a sublimation recrystallization method using a SiC seed crystal,
wherein a polycrystalline SiC substrate that is a SiC polycrystal produced by a sublimation recrystallization method and contains a greater amount of α-SiC than β-SiC is used as the SiC seed crystal.

2. The SiC polycrystal manufacturing method according to claim 1, wherein the polycrystalline SiC substrate contains at least one out of metallic elements vanadium, scandium, and titanium as a trace component.

3. The SiC polycrystal manufacturing method according to claim 2, wherein the polycrystalline SiC substrate contains nitrogen as a trace component.

4. The SiC polycrystal manufacturing method according to claim 3, wherein a polycrystalline SiC substrate in which concentration of the metallic elements is higher than a concentration of nitrogen is used as the polycrystalline SiC substrate.

5. The SiC polycrystal manufacturing method according to claim 4, wherein the polycrystalline SiC substrate further contains boron as a trace component.

6. The SiC polycrystal manufacturing method according to any one of claims 1 to 5, wherein the polycrystalline SiC substrate is disposed with an a-axis of the polycrystalline SiC substrate oriented along a growth direction of the SiC polycrystal.
